# EUROPÄISCHE PATENTSCHRIFT

(11) **EP 3 147 634 B1**
(45) Veröffentlichungstag und Bekanntmachung des Hinweises auf die Patenterteilung: **06.02.2019**
(21) Anmeldenummer: 16198918.1
(22) Anmeldetag: 11.03.2014
(51) Int. Cl.: G01F 1/716, G01N 24/08, G01R 33/563, G01R 33/30

(54) **KERNMAGNETISCHES DURCHFLUSSMESSGERÄT**
NUCLEAR MAGNETIC FLOW METER
DÉBITMÈTRE À RÉSONANCE MAGNÉTIQUE

(30) Priorität: 13.03.2013 DE 102013004267
(43) Veröffentlichungstag der Anmeldung: 29.03.2017
(62) Teilanmeldung aus: 14000853.3
(73) Patentinhaber: Krohne AG, 4019 Basel (CH)
(72) Erfinder: Pors, Jan Teunis Aart, 3262 EK Oud-Beijerland (NL); Ramondt, Jan-Willem, 481KL Breda (NL)
(74) Vertreter: Gesthuysen Patent- und Rechtsanwälte

(56) Entgegenhaltungen:
- EP-A1- 2 551 694
- WO-A1-01/36919
- WO-A1-2013/009400
- US-A- 3 471 774
- US-A- 4 785 245
- US-A- 4 901 018

## Beschreibung

Die Erfindung betrifft ein kernmagnetisches Durchflussmessgerät mit einem von einem mehrphasigen Medium durchströmbaren geraden Messrohr, einer um das Messrohr angeordneten Magnetisierungsvorrichtung zur Erzeugung eines Magnetfelds in dem durch das Messrohr strömenden Medium, wenigstens einer Gradientenspule zur Erzeugung eines Gradienten in dem Magnetfeld und wenigstens einer Signalspule zur Anregung des Mediums und/oder zur Detektion der Wirkung der Anregung, einem ersten Spulenträger und einem Gehäuse, wobei das Gehäuse entlang der Längsachse des Messrohrs eine erste Stirnseite und eine zweite Stirnseite aufweist, in der ersten Stirnseite eine erste Gehäuseöffnung und in der zweiten Stirnseite eine zweite Gehäuseöffnung vorgesehen ist, die Magnetisierungsvorrichtung im Innenraum des Gehäuses vorgesehen ist und das Gehäuse, abgesehen von den beiden Gehäuseöffnungen, dicht ist und wobei die Gradientenspule und die Signalspule im vom Magnetfeld durchsetzten Raum zwischen dem Messrohr und der Magnetisierungsvorrichtung angeordnet sind. Ein solches kernmagnetisches Durchflussmessgerät ist aus der WO 2013/009400 A1 bekannt.

Die Atomkerne der Elemente, die einen Kernspin besitzen, besitzen auch ein durch den Kernspin hervorgerufenes magnetisches Moment. Der Kernspin kann als ein durch einen Vektor beschreibbarer Drehimpuls aufgefasst werden und entsprechend kann auch das magnetische Moment durch einen Vektor beschrieben werden, der parallel zum Vektor des Drehimpulses ausgerichtet ist. Der Vektor des magnetischen Moments eines Atomkerns richtet sich bei Anwesenheit eines makroskopischen Magnetfelds parallel zu dem Vektor des makroskopischen Magnetfelds an der Stelle des Atomkerns aus. Dabei präzessiert der Vektor des magnetischen Moments des Atomkerns um den Vektor des makroskopischen Magnetfelds an der Stelle des Atomkerns. Die Frequenz der Präzession wird als Larmorfrequenz ω_{L} bezeichnet und ist proportional zum Betrag der Magnetfeldstärke *B.* Die Larmorfrequenz berechnet sich gemäß der Formel ω_{L} = γ *B,* in welcher γ das gyromagnetische Verhältnis ist, das für Wasserstoffkerne maximal ist. Die Präzession des magnetischen Moments eines Atomkerns ist ein magnetisches Wechselfeld mit der Larmorfrequenz, welches ein elektrisches Signal mit der gleichen Frequenz in eine Spule induzieren kann.

Messverfahren, welche die Präzession von Atomkernen eines Mediums bei Anwesenheit eines makroskopischen Magnetfelds durch Anregung mittels eines gesteuerten Magnetfelds beeinflussen und die Wirkung der Anregung auswerten, werden als kernmagnetische Resonanz-Messverfahren bezeichnet. Voraussetzung für die Messung eines mehrphasigen Mediums ist, dass die einzelnen Phasen des Mediums zu unterscheidbaren kernmagnetischen Resonanzen angeregt werden können.

Ein Beispiel für Messgeräte, welche kernmagnetische Resonanz-Messverfahren umsetzen, sind die eingangs genannten kernmagnetischen Durchflussmessgeräte. Diese können die Strömungsgeschwindigkeiten der einzelnen Phasen des Mediums im Messrohr und die relativen Anteile der einzelnen Phasen am mehrphasigen Medium messen. Kernmagnetische Durchflussmessgeräte können z. B. zur Durchflussmessung des aus Ölquellen geförderten mehrphasigen Mediums eingesetzt werden. Dieses Medium besteht im Wesentlichen aus den flüssigen Phasen Rohöl und Salzwasser und der gasförmigen Phase Erdgas, wobei alle Phasen die für kernmagnetische Resonanzen notwendigen Wasserstoffkerne enthalten und zu unterschiedlichen kernmagnetischen Resonanzen anregbar sind.

Die Messung des aus Ölquellen geförderten mehrphasigen Mediums kann auch mit Testseparatoren erfolgen. In einen Testseparator wird das geförderte Medium über einen Zeitraum eingeleitet, worauf der Testseparator die einzelnen Phasen des Mediums voneinander trennt und die Anteile der einzelnen Phasen an dem Medium bestimmt. Jedoch sind Testseparatoren im Gegensatz zu kernmagnetischen Durchflussmessgeräten nicht im Stande, Rohölanteile kleiner als 5 % zuverlässig zu messen. Da der Rohölanteil einer jeden Ölquelle stetig absinkt und der Rohölanteil einer Vielzahl von Ölquellen bereits geringer als 5 % ist, ist es derzeit nicht möglich, diese Ölquellen unter Verwendung von Testseparatoren wirtschaftlich auszubeuten. Um auch Ölquellen mit einem sehr geringen Rohölanteil weiterhin ausbeuten zu können, sind entsprechend genaue Durchflussmessgeräte für das aus mehreren Phasen bestehende Medium erforderlich. Hierfür kommen insbesondere kernmagnetische Durchflussmessgeräte in Frage.

Bei den eingangs erwähnten kernmagnetischen Durchflussmessgeräten wird das Magnetfeld, entlang dessen sich die magnetischen Momente der Atomkerne des mehrphasigen Mediums zunächst ausrichten, durch die Magnetisierungsvorrichtung und die Gradientenspulen erzeugt. Das von der Magnetisierungsvorrichtung erzeugte Magnetfeld ist homogen im durch das Messrohr strömenden Medium und wird für gewöhnlich von in der Magnetisierungsvorrichtung als Halbach-Array angeordneten Permanentmagneten erzeugt. Verschiedene Messverfahren bedingen einen Gradienten in dem das Medium durchdringenden Magnetfeld. Dieser Gradient wird durch Überlagerung des homogenen Magnetfelds mit dem durch die wenigstens eine Gradientenspule erzeugten inhomogenen Feld erzeugt.

Das gesteuerte Magnetfeld, welches die präzessierenden Atomkerne anregt, kann durch die wenigstens eine Signalspule erzeugt werden. Diese Signalspulen oder weitere Signalspulen können als Sensor für das von den präzessierenden Atomkernen erzeugte magnetische Wechselfeld dienen. Für gewöhnlich sind die Spulen, das sind die Gradientenspulen und die Signalspulen, im von dem Magnetfeld durchsetzten Raum zwischen der Magnetisierungsvorrichtung und dem Messrohr angeordnet.

Das Gehäuse nimmt im Innenraum zumindest die Magnetisierungsvorrichtung auf und dichtet den Innenraum gegenüber dem Außenraum ab. Das Verständnis von Dichtheit ist dabei vom Einsatzzweck des kernmagnetischen Durchflussmessgeräts abhängig. Die Dichtheit kann für Berührung und Fremdkörper einerseits und für Feuchtigkeit und Wasser andererseits gemäß EN 60529 spezifiziert werden. Dichtheit für Berührung und Fremdkörper wird über die Größe der Fremdkörper definiert und reicht bei den International Protection Codes bis zur Staubdichtheit (IP6x). Dichtheit in Bezug auf Feuchtigkeit und Wasser kann z. B. bei zeitweiligem Untertauchen gegeben sein (IPx7). Die Dichtheit kann auch in Bezug auf Explosionsschutz spezifiziert werden, und zwar durch die Explosionsschutzart. So kann die Dichtheit durch eine druckfeste Kapselung gemäß EN 60079-1 (ex-d) oder durch erhöhte Sicherheit gemäß EN 60079-7 (ex-e) spezifiziert sein.

Den aus dem Stand der Technik bekannten und eingangs beschriebenen kernmagnetischen Durchflussmessgeräten gemein sind Gehäuse, deren Herstellung aufgrund der Anforderungen an die Dichtheit aufwändig ist. Insbesondere ist die Konstruktion und Produktion des Gehäuses im Bereich zwischen dem Messrohr und der Magnetisierungsvorrichtung aufwändig und kostenintensiv.

Aufgabe der vorliegenden Erfindung ist daher die Angabe eines kernmagnetischen Durchflussmessgeräts mit einem verbesserten und insbesondere vereinfachten Aufbau.

Das erfindungsgemäße kernmagnetische Durchflussmessgerät, bei dem die zuvor hergeleitete und aufgezeigte Aufgabe gelöst ist, ist zunächst und im Wesentlichen dadurch gekennzeichnet, dass die erste Gehäuseöffnung und die zweite Gehäuseöffnung zur Durchführung des Messrohrs ausgebildet sind, dass die wenigstens eine Gradientenspule und die wenigstens eine Signalspule auf dem ersten Spulenträger angeordnet sind bzw. ist, dass zwischen dem ersten Spulenträger und der ersten Stirnseite des Gehäuses eine erste Spulenaufhängung und zwischen dem ersten Spulenträger und der zweiten Stirnseite des Gehäuses eine zweite Spulenaufhängung ausgebildet ist, dass die Oberseite des ersten Spulenträgers zumindest in einem ersten Abschnitt zwischen der ersten Spulenaufhängung und der zweiten Spulenaufhängung eine geschlossene Fläche ist, dass die erste Spulenaufhängung den ersten Spulenträger mit der ersten Stirnseite abdichtet, die zweite Spulenaufhängung den ersten Spulenträger mit der zweiten Stirnseite abdichtet und das Gehäuse zusammen mit dem ersten Spulenträger und den Spulenaufhängungen dicht ist und dass der erste Spulenträger zur Durchströmung mit dem Medium ausgebildet ist.

Durch die Ausbildung des ersten Spulenträgers zur Durchströmung mit dem Medium entfällt das Messrohr, wodurch in radialer Ausdehnung in Bezug auf die Längsachse des Messrohrs noch kompaktere kernmagnetische Durchflussmessgeräte möglich sind. Die Ausbildung des ersten Spulenträgers zur Durchströmung mit dem Medium beinhaltet im Wesentlichen eine ausreichende Druckfestigkeit gegenüber dem Druck des Mediums, eine ausreichende chemische Beständigkeit gegenüber den Bestandteilen des Mediums und selbstverständlich auch eine geringe Abnutzung durch das Strömen des Mediums.

Das erfindungsgemäße kernmagnetische Durchflussmessgerät hat gegenüber dem aus dem Stand der Technik bekannten kernmagnetischen Durchflussmessgeräten der eingangs genannten Art zunächst den Vorteil einer Reduktion der Anzahl der Komponenten, wodurch der Aufbau vereinfacht ist. Durch die zusätzliche Auslegung des ersten Spulenträgers als Teil des Gehäuses entfällt das zuvor notwendige separate Gehäuseelement, welches den Innenraum des Gehäuses im ersten Abschnitt gegenüber dem Außenraum abdichtet. Der Entfall dieses Gehäuseelements ermöglicht in radialer Ausdehnung in Bezug auf die Längsachse des Messrohrs kompaktere kernmagnetische Durchflussmessgeräte.

Bei einer bevorzugten Ausgestaltung der Erfindung ist vorgesehen, dass der erste Spulenträger zumindest im ersten Abschnitt rohrförmig ausgebildet ist und der rohrförmige Abschnitt des ersten Spulenträgers in die beiden Spulenaufhängungen entlang der Längsachse des Messrohrs einschiebbar ist. Rohrförmig ist vorliegend jede geschlossene äußere Querschnittskontur des ersten Spulenträgers in Bezug auf die Längsachse. Insbesondere ist demnach nicht nur eine kreisrunde äußere Querschnittskontur des ersten Spulenträgers möglich. Die Einschiebbarkeit des ersten Spulenträgers ist im ersten Abschnitt dadurch gewährleistet, dass die Querschnittsfläche des rohrförmigen Abschnitts des ersten Spulenträgers an die freie Querschnittsfläche zwischen dem Messrohr und der Magnetisierungsvorrichtung angepasst ist. Durch die Einschiebbarkeit des ersten Spulenträgers, der auch gleichzeitig das Gehäuse abdichtet, wird der Zusammenbau des erfindungsgemäßen kernmagnetischen Durchflussmessgeräts vereinfacht.

In einer weiteren bevorzugten Ausgestaltung des erfindungsgemäßen kernmagnetischen Durchflussmessgeräts weist der erste Spulenträger einen Flansch mit einer an die erste Stirnseite des Gehäuses angrenzenden Flanschseite auf und ist zwischen der ersten Stirnseite und der Flanschseite ein Dichtmittel angeordnet. Darüber hinaus ist an der zweiten Stirnseite des Gehäuses um die zweite Gehäuseöffnung ein Trägerring mit einer ersten und einer zweiten Ringseite angeordnet, wobei die erste Ringseite an die zweite Stirnseite des Gehäuses angrenzt und die zweite Ringseite an die Oberseite des ersten Spulenträgers angrenzt. Zwischen der ersten Ringseite des Trägerrings und der zweiten Stirnseite des Gehäuses ist ein Dichtmittel angeordnet, und zwischen der zweiten Ringseite des Trägerrings und der Oberseite des ersten Spulenträgers ist ebenfalls ein Dichtmittel angeordnet. Die Dichtmittel gewährleisten eine Dichtheit entsprechend den an das Gehäuse gestellten Anforderungen.

In der ersten und in der zweiten Ringseite des Trägerrings und in der Flanschseite des Flansches können Ausnehmungen für die Aufnahme der Dichtmittel vorgesehen sein. Als Kontur für die Ausnehmungen bietet sich der Kreis an. Als Dichtmittel bieten sich Dichtungen aus einem elastischen Material und entsprechend der Kontur der Ausnehmungen in Ringform an, welche an den Kontaktstellen zusammengepresst werden und auf diese Weise die Dichtheit bewirken.

Der Flansch des Spulenkörpers kann mit Bohrungen zur Durchführung von Schrauben versehen sein, und im Gehäuse können an der ersten Stirnseite Gewinde zur Aufnahme der Schrauben ausgebildet sein. Die beiden Spulenaufhängungen gewährleisten zusammen mit der Verschraubung eine Fixierung des ersten Spulenträgers am Gehäuse.

Wenn der erste Spulenträger zumindest im ersten Abschnitt rohrförmig ausgebildet ist, bietet es sich an, zwischen dem in die Ausnehmung in der zweiten Ringseite des Trägerrings eingesetzten Dichtmittel und der Oberseite des rohrförmigen Abschnitts des ersten Spulenträgers auf der Oberseite des rohrförmigen Abschnitts des ersten Spulenträgers einen Adapter anzuordnen; der Adapter ermöglicht zusammen mit dem Dichtmittel eine Bewegung des ersten Spulenträgers entlang der Längsachse des Messrohrs ohne Beeinträchtigung der Dichtheit. Ist der erste Spulenträger am Flansch mit dem Gehäuse verschraubt, erlaubt dieser Adapter zusammen mit dem Dichtmittel eine Längsbewegung des ersten Spulenträgers, wie sie z. B. durch unterschiedliche Wärmedehnungen des ersten Spulenträgers und des Gehäuses entsteht. Auf diese Weise können mechanische Spannungen im Gehäuse und im ersten Spulenträger vermieden werden.

In einer beispielhaften, nicht erfindungsgemäßen Ausgestaltung eines kernmagnetischen Durchflussmessgeräts ist wenigstens die Gradientenspule oder wenigstens eine der Gradientenspulen und/oder die Signalspule oder wenigstens eine der Signalspulen auf einem zweiten Spulenträger angeordnet. Dieser zweite Spulenträger kann auf dem ersten Spulenträger angeordnet sein. Die Anordnung kann entweder zwischen dem Messrohr und dem ersten Spulenträger oder zwischen dem ersten Spulenträger und der Magnetisierungsvorrichtung sein.

Ist der erste Spulenträger im ersten Abschnitt rohrförmig ausgebildet, kann es vorteilhaft sein, den zweiten Spulenträger in einem zweiten Abschnitt rohrförmig auszubilden, und zwar derart rohrförmig auszubilden, dass der rohrförmige Abschnitt des zweiten Spulenträgers in den rohrförmigen Abschnitt des ersten Spulenträgers entlang der Längsachse des Messrohrs einschiebbar ist. Vorzugsweise weist auch der zweite Spulenträger einen Flansch auf. Dieser Flansch kann mit Bohrungen zur Durchführung von Schrauben versehen sein, und im Gehäuse an der ersten Stirnseite können Gewinde zur Aufnahme der Schrauben ausgebildet sein.

Wenn sowohl der erste Spulenträger mit einem Flansch und der Flansch mit Bohrungen zur Durchführung von Schrauben versehen ist als auch der zweite Spulenträger mit einem Flansch und der Flansch mit Bohrungen zur Durchführung von Schrauben versehen ist, bietet es sich an, die Bohrungen auf dem ersten Spulenträger und dem zweiten Spulenträger fluchtend anzuordnen, so dass die beiden Spulenträger mit den gleichen Schrauben am Gehäuse befestigbar sind. Auf diese Weise vereinfacht sich der Zusammenbau des kernmagnetischen Durchflussmessgeräts weiter.

Auch kann es vorteilhaft sein, auf dem ersten Spulenträger entweder die Gradientenspulen und auf dem zweiten Spulenträger die Signalspulen oder auf dem ersten Spulenträger die Signalspulen und auf dem zweiten Spulenträger die Gradientenspulen anzuordnen. Dadurch sind die Baugruppen zur Erzeugung des Gradienten im Magnetfeld und zur Anregung und zur Detektion der Wirkung der Anregung voneinander getrennt und damit auch getrennt austauschbar und an verschiedene Einsatzzwecke anpassbar. Selbstverständlich können auch sämtliche Gradientenspulen und Signalspulen auf dem ersten Spulenträger angeordnet sein. Da sowohl der erste Spulenträger als auch der zweite Spulenträger zumindest teilweise im Magnetfeld angeordnet sind, müssen sie zumindest in diesen Teilen aus einem Material bestehen sein, welches das Magnetfeld nicht beeinträchtigt. Daher bieten sich als Materialien für die beiden Spulenträger Faserverbundwerkstoffe an, insbesondere glasfaserverstärkte Verbundwerkstoffe. Selbstverständlich können die beiden Spulenträger in Bereichen, die nicht im Magnetfeld liegen, auch aus anderen Materialien hergestellt sein.

Im Einzelnen gibt es nun verschiedene Möglichkeiten, das erfindungsgemäße kernmagnetische Durchflussmessgerät auszugestalten und weiterzubilden. Dazu wird verwiesen auf die dem Patentanspruch 1 nachgeordneten Patentansprüche und auf die Beschreibung bevorzugter Ausführungsbeispiele in Verbindung mit der Zeichnung. In der Zeichnung zeigen
- Fig. 1: ein erstes Ausführungsbeispiel eines kernmagnetischen Durchflussmessgeräts mit einem Messrohr und einem ersten und einem zweiten Spulenträger,
- Fig. 2: ein zweites Ausführungsbeispiel mit einem Messrohr und einem ersten Spulenträger und
- Fig. 3: ein Ausführungsbeispiel eines erfindungsgemäßen kernmagnetischen Durchflussmessgeräts mit einem ersten Spulenträger.

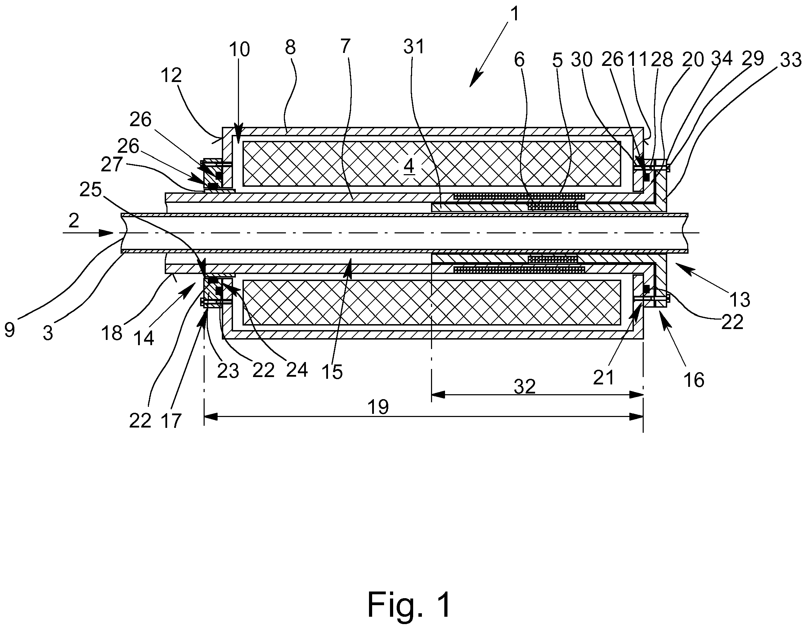

Fig. 1 zeigt die wesentlichen Elemente eines ersten Ausführungsbeispiels eines kernmagnetischen Durchflussmessgeräts 1. Ein mehrphasiges Medium 2 strömt durch ein gerades Messrohr 3. Um das Messrohr 3 ist eine Magnetisierungsvorrichtung 4 zur Erzeugung eines homogenen Magnetfelds in dem durch das Messrohr 3 strömenden Medium 2 angeordnet. Eine Gradientenspule 5 erzeugt ein inhomogenes Magnetfeld in dem durch das Messrohr 3 strömenden Medium 2, und die Überlagerung der beiden Magnetfelder resultiert in dem Medium 2 in einem Magnetfeld mit einem Gradienten. Eine Signalspule 6 dient sowohl zur Anregung des Mediums 2 als auch zur Detektion der Wirkung der Anregung. Die Gradientenspule 5 ist auf einem ersten Spulenträger 7 angeordnet. Das kernmagnetische Durchflussmessgerät 1 umfasst auch ein Gehäuse 8, wobei das Gehäuse 8 entlang der Längsachse 9 des Messrohrs 3 eine erste Stirnseite 11 und eine zweite Stirnseite 12 aufweist. In der ersten Stirnseite 11 ist eine erste Gehäuseöffnung 13 und in der zweiten Stirnseite 12 ist eine zweite Gehäuseöffnung 14 zur Durchführung des Messrohrs 3 vorgesehen. Die Magnetisierungsvorrichtung ist im Innenraum 10 des Gehäuses 8 vorgesehen. Das Gehäuse 8 ist abgesehen von den beiden Gehäuseöffnungen 13, 14 dicht gemäß IP 67. Demnach ist es staubdicht und dicht bei zeitweiligem Untertauchen. Sowohl die Gradientenspule 5 als auch die Signalspule 6 sind im vom Magnetfeld durchsetzten Raum 15 zwischen dem Messrohr 3 und der Magnetisierungsvorrichtung 4 angeordnet.

Zwischen dem ersten Spulenträger 7 und der ersten Stirnseite 11 ist eine erste Spulenaufhängung 16 und zwischen dem ersten Spulenträger 7 und der zweiten Stirnseite 12 ist eine zweite Spulenaufhängung 17 ausgebildet. Die Oberseite 18 des ersten Spulenträgers 7 ist in einem ersten Abschnitt 19 zwischen der ersten Spulenaufhängung 16 und der zweiten Spulenaufhängung 17 eine geschlossene Fläche, und zwar ist der erste Spulenträger 7 in dem ersten Abschnitt rohrförmig mit einer kreisrunden Querschnittskontur.

An den rohrförmigen Abschnitt des ersten Spulenträgers 7 ist ein Flansch 20 angeformt. Der Flansch 20 grenzt mit einer Flanschseite 21 an die erste Stirnseite 11 des Gehäuses 8. Zwischen der ersten Stirnseite 11 und der Flanschseite 21 des Flansches 20 ist ein Dichtmittel 22 angeordnet. An der zweiten Stirnseite 12 des Gehäuses 8 um die zweite Gehäuseöffnung 14 ist ein Trägerring 23 mit einer ersten Ringseite 24 und einer zweiten Ringseite 25 angeordnet. Die erste Ringseite 24 grenzt an die zweite Stirnseite 12 des Gehäuses 8 und die zweite Ringseite 25 grenzt an die Oberseite 18 des rohrförmigen Abschnitts des ersten Spulenträgers 7. Sowohl zwischen der ersten Ringseite 24 des Trägerrings 23 und der zweiten Stirnseite 12 des Gehäuses 8 als auch zwischen der zweiten Ringseite 25 des Trägerrings 23 und der Oberseite 18 des rohrförmigen Abschnitts des ersten Spulenträgers 7 ist jeweils ein Dichtmittel 22 angeordnet. In der ersten Ringseite 24 und der zweiten Ringseite 25 des Trägerrings 23 und in der Flanschseite 21 des Flansches 20 sind konzentrische Ausnehmungen 26 für elastische ringförmige Dichtungen als Dichtmittel 22 vorgesehen.

Der erste Spulenträger 7 besteht im Wesentlichen aus einem rohrförmigen Abschnitt und einem an diesen angeformten Flansch 20. Die Querschnittsfläche in Bezug auf die Längsachse 9 des rohrförmigen Abschnitts des ersten Spulenträgers 7 ist dabei derart an den freien Raum in radialer Richtung in Bezug auf die Längsachse 9 des Messrohrs 3 zwischen dem Messrohr 3 und der Magnetisierungsvorrichtung 4 angepasst, dass der rohrförmige Abschnitt des ersten Spulenträgers 7 entlang der Längsachse 9 in die beiden Spulenaufhängungen 16, 17 einschiebbar ist.

Zwischen dem in die Ausnehmung 26 in der zweiten Ringseite 25 des Trägerrings 23 eingesetzten Dichtmittel 22 und der Oberseite 18 des rohrförmigen Abschnitts des ersten Spulenträgers 7 ist auf der Oberseite 18 des rohrförmigen Abschnitts des ersten Spulenträgers 7 ein Adapter 27 angeordnet. Bei diesem Adapter 27 handelt es sich um einen Metallring, der mit dem Dichtmittel 22 in Kontakt steht und dicht abschließt. Der Adapter 27 gewährleistet zusammen mit dem Dichtmittel 22 eine Bewegung des ersten Spulenträgers 7 entlang der Längsachse 9 des Messrohrs 3 ohne Beeinträchtigung der Dichtheit des Gehäuses 8.

Im Flansch 20 sind parallel zur Längsachse 9 des Messrohrs 3 Bohrungen 28 zur Durchführung von Schrauben 29 auf einem konzentrisch um die Längsachse 9 angeordneten Kreis vorgesehen und gleichmäßig auf diesem Kreis verteilt. Auf der ersten Stirnseite 11 im Gehäuse 8 sind mit den Bohrungen 28 fluchtende Gewinde 30 für die Schrauben 29 ausgebildet.

Die erste Spulenaufhängung 16 umfasst den mit der Ausnehmung 26 und den Bohrungen 28 versehenen Flansch 20 des ersten Spulenträgers 7, das Dichtmittel 22 für diese Ausnehmung 26, die Gewinde 30 in der ersten Stirnseite 11 des Gehäuses 8 und die Schrauben 29. Die zweite Spulenaufhängung 17 umfasst den Trägerring 23, die mit einem Dichtmittel 22 versehene Ausnehmung 26 in der ersten Ringseite 24, die mit einem Dichtmittel 22 versehene Ausnehmung 26 in der zweiten Ringseite 25 und den Adapter 27. Folglich dichtet die erste Spulenaufhängung 16 den ersten Spulenträger 7 mit der ersten Stirnseite 11 ab und die zweite Spulenaufhängung 17 dichtet den ersten Spulenträger 7 mit der zweiten Stirnseite 12 ab. Der Innenraum 10 des Gehäuses 8 ist damit dicht gemäß IP 67 gegenüber dem Außenraum abgeschlossen.

Auf einem zweiten Spulenträger 31 ist die Signalspule 6 angeordnet. Der zweite Spulenträger 31 ist in einem zweiten Abschnitt 32 derart rohrförmig ausgebildet, dass der rohrförmige Abschnitt des zweiten Spulenträgers 31 in den Raum zwischen dem rohrförmigen Abschnitt des ersten Spulenträgers 7 und dem Messrohr 3 entlang der Längsachse 9 einschiebbar ist. An den rohrförmigen Abschnitt des zweiten Spulenträgers 31 ist ein Flansch 33 angeformt. Der Flansch 33 des zweiten Spulenträgers 31 ist mit Bohrungen 34 versehen, welche fluchtend mit den Bohrungen 28 im Flansch 20 sind. Somit ist es möglich, den ersten Spulenträger 7 und den zweiten Spulenträger 31 mit den gleichen Schrauben 29 an der ersten Stirnseite 11 des Gehäuses 8 zu fixieren.

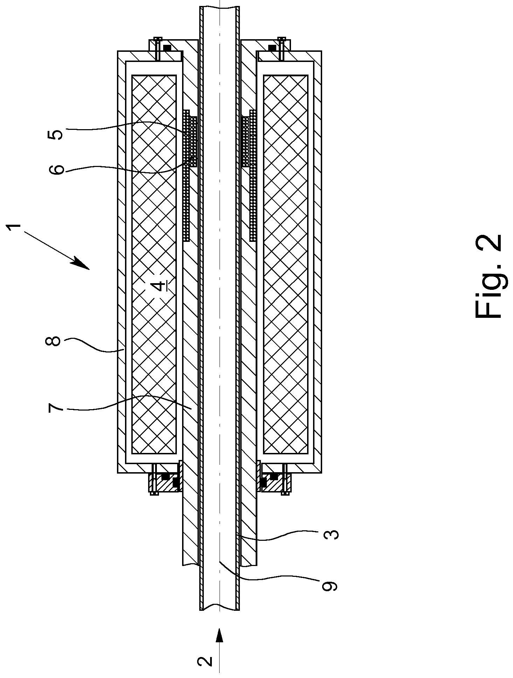

In Fig. 2 sind die wesentlichen Elemente eines zweiten Ausführungsbeispiels eines kernmagnetischen Durchflussmessgeräts 1 dargestellt. Im Folgenden wird nur auf die Unterschiede zu dem in Fig. 1 dargestellten ersten Ausführungsbeispiels eingegangen. Im in Fig. 2 dargestellten Ausführungsbeispiel ist neben der Gradientenspule 5 auch die Signalspule 6 auf dem ersten Spulenträger 7 angeordnet, so dass ein zweiter Spulenträger 31 nicht erforderlich ist. Auf diese Weise kann die Anzahl der Komponenten des kernmagnetischen Durchflussmessgeräts 1 weiter reduziert und damit der Aufbau weiter vereinfacht werden.

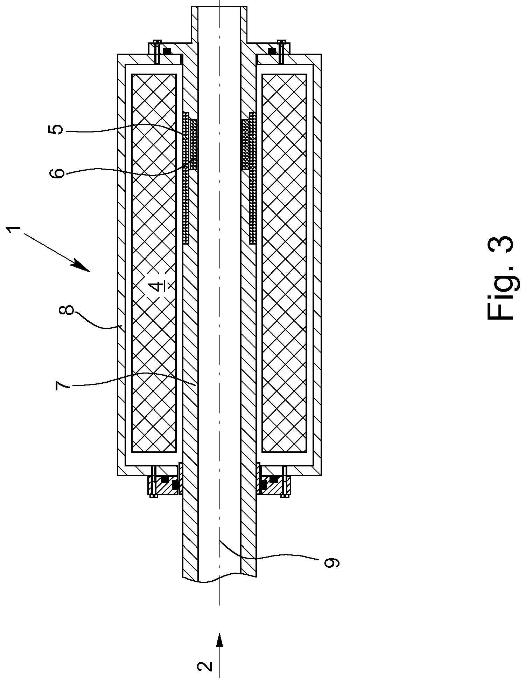

In Fig. 3 sind die wesentlichen Komponenten eines Ausführungsbeispiels eines erfindungsgemäßen Durchflussmessgeräts 1 dargestellt. Auch hier wird im Folgenden nur auf die Unterschiede zum in Fig. 1 dargestellten Ausführungsbeispiel eingegangen. Im in Fig. 3 dargestellten Ausführungsbeispiel sind zum einen, wie schon im in Fig. 2 dargestellten Ausführungsbeispiel, sowohl die Gradientenspule 5 als auch die Signalspule 6 auf dem ersten Spulenträger 7 angeordnet. Darüber hinaus ist der erste Spulenträger 7 aber auch zur Durchströmung mit dem Medium 2 ausgebildet, wodurch neben dem zweiten Spulenträger 31 auch noch das Messrohr 3 entfällt.

### Bezugszeichen:

- 1.: kernmagnetisches Durchflussmessgerät
- 2.: Medium
- 3.: Messrohr
- 4.: Magnetisierungsvorrichtung
- 5.: Gradientenspule
- 6.: Signalspule
- 7.: erster Spulenträger
- 8.: Gehäuse
- 9.: Längsachse
- 10.: Innenraum
- 11.: erste Stirnseite
- 12.: zweite Stirnseite
- 13.: erste Gehäuseöffnung
- 14.: zweite Gehäuseöffnung
- 15.: Raum
- 16.: erste Spulenaufhängung
- 17.: zweite Spulenaufhängung
- 18.: Oberseite
- 19.: erster Abschnitt
- 20.: Flansch des ersten Spulenträgers
- 21.: Flanschseite
- 22.: Dichtmittel
- 23.: Trägerring
- 24.: erste Ringseite
- 25.: zweite Ringseite
- 26.: Ausnehmung
- 27.: Adapter
- 28.: Bohrung im Flansch 20
- 29.: Schraube
- 30.: Gewinde
- 31.: zweiter Spulenträger
- 32.: zweiter Abschnitt
- 33.: Flansch des zweiten Spulenträgers
- 34.: Bohrung im Flansch 33

## Patentansprüche

1. Kernmagnetisches Durchflussmessgerät (1) mit einem von einem mehrphasigen Medium (2) durchströmbaren geraden Messrohr (3), einer um das Messrohr (3) angeordneten Magnetisierungsvorrichtung (4) zur Erzeugung eines Magnetfelds in dem durch das Messrohr (3) strömenden Medium (2), wenigstens einer Gradientenspule (5) zur Erzeugung eines Gradienten in dem Magnetfeld und wenigstens einer Signalspule (6) zur Anregung des Mediums (2) und/oder zur Detektion der Wirkung der Anregung, einem ersten Spulenträger (7) und einem Gehäuse (8),
wobei das Gehäuse (8) entlang der Längsachse (9) des Messrohrs (3) eine erste Stirnseite (11) und eine zweite Stirnseite (12) aufweist, in der ersten Stirnseite (11) eine erste Gehäuseöffnung (13) und in der zweiten Stirnseite (12) eine zweite Gehäuseöffnung (14) vorgesehen ist, die Magnetisierungsvorrichtung (4) im Innenraum (10) des Gehäuses (8) vorgesehen ist und das Gehäuse (8), abgesehen von den beiden Gehäuseöffnungen (13, 14), dicht ist,
wobei die wenigstens eine Gradientenspule (5) und die wenigstens eine Signalspule (6) im vom Magnetfeld durchsetzten Raum (15) zwischen dem Messrohr (3) und der Magnetisierungsvorrichtung (4) angeordnet sind,
wobei die erste Gehäuseöffnung (13) und die zweite Gehäuseöffnung (14) zur Durchführung des Messrohrs (3) ausgebildet sind,
wobei die wenigstens eine Gradientenspule (5) und die wenigstens eine Signalspule (6) auf dem ersten Spulenträger (7) angeordnet sind bzw. ist,
wobei zwischen dem ersten Spulenträger (7) und der ersten Stirnseite (11) des Gehäuses (8) eine erste Spulenaufhängung (16) und zwischen dem ersten Spulenträger (7) und der zweiten Stirnseite (12) des Gehäuses (8) eine zweite Spulenaufhängung (17) ausgebildet ist,
wobei die Oberseite (18) des ersten Spulenträgers (7) zumindest in einem ersten Abschnitt (19) zwischen der ersten Spulenaufhängung (16) und der zweiten Spulenaufhängung (17) eine geschlossene Fläche ist,
wobei die erste Spulenaufhängung (16) den ersten Spulenträger (7) mit der ersten Stirnseite (11) des Gehäuses (8) abdichtet, die zweite Spulenaufhängung (17) den ersten Spulenträger (7) mit der zweiten Stirnseite (12) des Gehäuses (8) abdichtet und das Gehäuse (8) zusammen mit dem ersten Spulenträger (7) und den Spulenaufhängungen (16, 17) dicht ist und
wobei der erste Spulenträger (7) zur Durchströmung mit dem Medium (2) ausgebildet ist und so der erste Spulenträger (7) das Messrohr (3) bildet, sodass das Messrohr (3) als separates Bauteil entfällt.

2. Kernmagnetisches Durchflussmessgerät nach Anspruch 1, **dadurch gekennzeichnet, dass** der erste Spulenträger (7) zumindest im ersten Abschnitt (19) rohrförmig ausgebildet ist und der rohrförmige Abschnitt des ersten Spulenträgers (7) in die beiden Spulenaufhängungen (16, 17) entlang der Längsachse (9) einschiebbar ist.

3. Kernmagnetisches Durchflussmessgerät nach Anspruch 1 oder 2, **dadurch gekennzeichnet, dass** der erste Spulenträger (7) einen Flansch (20) mit einer an die erste Stirnseite (11) des Gehäuses (8) angrenzenden Flanschseite (21) aufweist und zwischen der ersten Stirnseite (11) des Gehäuses (8) und der Flanschseite (21) des Flansches (20) ein Dichtmittel (22) angeordnet ist und dass an der zweiten Stirnseite (12) des Gehäuses (8) um die zweite Gehäuseöffnung (14) ein Trägerring (23) mit einer ersten Ringseite (24) und einer zweiten Ringseite (25) angeordnet ist, die erste Ringseite (24) des Trägerrings (23) an die zweite Stirnseite (12) des Gehäuses (8) angrenzt, die zweite Ringseite (25) des Trägerrings (23) an der Oberseite (18) des ersten Spulenträgers (7) angrenzt, zwischen der ersten Ringseite (24) des Trägerrings (23) und der zweiten Stirnseite (12) des Gehäuses (8) ein Dichtmittel (22) angeordnet ist und zwischen der zweiten Ringseite (25) des Trägerrings (23) und der Oberseite (18) des ersten Spulenträgers (7) ein Dichtmittel (22) angeordnet ist.

4. Kernmagnetisches Durchflussmessgerät nach Anspruch 3, **dadurch gekennzeichnet, dass** in den beiden Ringseiten (24, 25) des Trägerrings (23) und in der Flanschseite (21) des Flansches (20) Ausnehmungen (26) für die Aufnahme der Dichtmittel (22) vorgesehen sind.

5. Kernmagnetisches Durchflussmessgerät nach Anspruch 4, **dadurch gekennzeichnet, dass** zwischen dem in die Ausnehmung (26) in der zweiten Ringseite (25) des Trägerrings (23) eingesetzten Dichtmittel (22) und der Oberseite (18) des rohrförmigen Abschnitts des ersten Spulenträgers (7) auf der Oberseite (18) des rohrförmigen Abschnitts des ersten Spulenträgers (7) ein Adapter (27) angeordnet ist und der Adapter (27) zusammen mit dem Dichtmittel (22) eine Bewegung des ersten Spulenträgers (7) entlang der Längsachse (9) des Messrohrs (3) ohne Beeinträchtigung der Dichtheit ermöglicht.

6. Kernmagnetisches Durchflussmessgerät nach einem der Ansprüche 3 bis 5, **dadurch gekennzeichnet, dass** der Flansch (20) mit Bohrungen (28) zur Durchführung von Schrauben (29) versehen ist und im Gehäuse (8) an der ersten Stirnseite (11) Gewinde (30) zur Aufnahme der Schrauben (29) ausgebildet sind.

7. Kernmagnetisches Durchflussmessgerät nach einem der Ansprüche 1 bis 6, **dadurch gekennzeichnet, dass** der erste Spulenträger (7) im Wesentlichen aus einem Faserverbundwerkstoff besteht, insbesondere im Wesentlichen aus einem glasfaserverstärkten Verbundwerkstoff.

## Claims

1. Nuclear magnetic flowmeter (1) having a straight measuring tube (3) through which a multi-phase medium (2) can flow, a magnetizing device (4) arranged around the measuring tube (3) for generating a magnetic field in the medium (2) flowing through the measuring tube (3), at least one gradient coil (5) for generating a gradient in the magnetic field and at least one signal coil (6) for excitation of the medium (2) and/or for detection of the effect of the excitation, a first coil carrier (7) and a housing (8),
wherein the housing (8) has a first end face (11) and a second end face (12) along the longitudinal axis (9) of the measuring tube (3), a first housing opening (13) is provided in the first end face (11) and a second housing opening (14) is provided in the second end face (12), the magnetizing device (4) is provided in the interior (10) of the housing (8), and the housing (8) is sealed, with the exception of the two housing openings (13, 14),
wherein the at least one gradient coil (5) and the at least one signal coil (6) are arranged in the space (15) through which the magnetic field passes between the measuring tube (3) and the magnetizing device (4),
wherein the first housing opening (13) and the second housing opening (14) are designed for the passage of the measuring tube (3),
wherein the at least one gradient coil (5) and the at least one signal coil (6) are arranged on the first coil carrier (7),
wherein a first coil suspension (16) is formed between the first coil carrier (7) and the first end face (11) of the housing (8) and a second coil suspension (17) is formed between the first coil carrier (7) and the second end face (12) of the housing (8),
wherein the upper side (18) of the first coil carrier (7) is a closed surface at least in a first section (19) between the first coil suspension (16) and the second coil suspension (17),
wherein the first coil suspension (16) seals the first coil carrier (7) with the first end face (11) of the housing (8), the second coil suspension (17) seals the first coil carrier (7) with the second end face (12) of the housing (8) and, together with the first coil carrier (7) and the coil suspensions (16, 17), the housing (8) is sealed, and
wherein the first coil carrier (7) is designed for the medium (2) to flow through it and the first coil carrier (7) thus forms the measuring tube (3), so that the measuring tube (3) is not a separate component.

2. Nuclear magnetic flowmeter according to claim 1, **characterized in that** the first coil carrier (7) is tubular at least in the first section (19) and the tubular section of the first coil carrier (7) can be pushed into the two coil suspensions (16, 17) along the longitudinal axis (9).

3. Nuclear magnetic flowmeter according to claim 1 or 2, **characterized in that** the first coil carrier (7) has a flange (20) with a flange side (21) adjacent to the first end face (11) of the housing (8) and a sealing means (22) is arranged between the first end face (11) of the housing (8) and the flange side (21) of the flange (20), and that a carrier ring (23) with a first ring side (24) and a second ring side (25) is arranged on the second end face (12) of the housing (8) around the second housing opening (14), the first ring side (24) of the carrier ring (23) is adjacent to the second end face (12) of the housing (8), the second ring side (25) of the carrier ring (23) is adjacent to the upper side (18) of the first coil carrier (7), a sealing means (22) is arranged between the first ring side (24) of the carrier ring (23) and the second end face (12) of the housing (8) and a sealing means (22) is arranged between the second ring side (25) of the carrier ring (23) and the upper side (18) of the first coil carrier (7).

4. Nuclear magnetic flowmeter according to claim 3, **characterized in that** recesses (26) for receiving the sealing means (22) are provided in the two ring sides (24, 25) of the carrier ring (23) and in the flange side (21) of the flange (20).

5. Nuclear magnetic flowmeter according to claim 4, **characterized in that** an adapter (27) is arranged on the upper side (18) of the tubular portion of the first coil carrier (7) between the sealing means (22) inserted in the recess (26) in the second ring side (25) of the carrier ring (23) and the upper side (18) of the tubular portion of the first coil carrier (7) and the adapter (27), together with the sealing means (22), allows for movement of the first coil carrier (7) along the longitudinal axis (9) of the measuring tube (3) without affecting the sealing.

6. Nuclear magnetic flowmeter according to any one of claims 3 to 5, **characterized in that** the flange (20) is provided with bores (28) for the passage of screws (29) and threads (30) for receiving the screws (29) are formed in the housing (8) at the first end face (11).

7. Nuclear magnetic flowmeter according to any one of claims 1 to 6, **characterized in that** the first coil carrier (7) consists essentially of a fiber composite material, in particular consists essentially of a fiberglass-reinforced composite material.

## Revendications

1. Débitmètre (1) à résonance magnétique nucléaire, avec un tube de mesurage (3) rectiligne susceptible d'être traversé par un milieu (2) polyphasique, un dispositif de magnétisation (4) placé autour du tube de mesurage (3) pour générer un champ magnétique dans le milieu (2) circulant à travers le tube de mesurage (3), au moins une bobine à gradient (5) destinée à générer un gradient dans le champ magnétique et au moins une bobine de signal (6) destinée à exciter le milieu (2) et/ou à détecter l'effet de l'excitation, un premier porte-bobines (7) et un boîtier (8),
le long de l'axe longitudinal (9) du tube de mesurage (3), le boîtier (8) comportant une première face frontale (11) et une seconde face frontale (12), dans la première face frontale (11) étant prévu un premier orifice (13) de boîtier et dans la seconde face frontale (12) étant prévu un second orifice (14) de boîtier, le dispositif de magnétisation (4) étant prévu dans l'espace intérieur (10) du boîtier (8) et, hormis les deux orifices (13, 14) de boîtier, le boîtier (8) étant étanche,
l'au moins une bobine à gradient (5) et/ou l'au moins une bobine de signal (6) étant placée ou placées dans l'espace (15) traversé par le champ magnétique, entre le tube de mesurage (3) et le dispositif de magnétisation (4),
le premier orifice (13) de boîtier et le second orifice (14) de boîtier étant conçus pour passer à travers le tube de mesurage (3),
l'au moins une bobine à gradient (5) et l'au moins une bobine de signal étant placée(s) sur le premier porte-bobines (7),
entre le premier porte-bobines (7) et la première face frontale (11) du boîtier (8) étant conçue une première suspension (16) de bobine et entre le premier porte-bobines (7) et la seconde face frontale (12) du boîtier (8) étant conçue une seconde suspension (17) de bobine, au moins dans une première portion (19) entre la première suspension (16) de bobine et la seconde suspension (17) de bobine, la face supérieure (18) du premier porte-bobines (7) étant une surface fermée,
la première suspension (16) de bobine assurant l'étanchéité du premier porte-bobines (7) avec la première face frontale (11) du boîtier (8), la seconde suspension (17) de bobine assurant l'étanchéité du premier porte-bobines (7) avec la seconde face frontale (12) du boîtier (8) et le boîtier (8) étant étanche, en commun avec le premier porte-bobines (7) et les suspensions (16, 17) de bobines et
le premier porte-bobines (7) étant conçu pour la circulation du milieu (2) et le premier porte-bobines (7) formant ainsi le tube de mesurage (3) de sorte que le tube de mesurage (3) peut ne pas être un composant séparé.

2. Débitmètre à résonance magnétique nucléaire selon la revendication 1, **caractérisé en ce qu'**au moins dans la première portion (19) le premier porte-bobines (7) est conçu de forme tubulaire et la portion de forme tubulaire du premier porte-bobines (7) est emboîtable dans les deux suspensions (16, 17) de bobines, le long de l'axe longitudinal (9).

3. Débitmètre à résonance magnétique nucléaire selon la revendication 1 ou 2, **caractérisé en ce que** le premier porte-bobines (7) comporte une bride (20) avec un côté de bride (21) adjacent à la première face frontale (11) du boîtier (8) et entre la première face frontale (11) du boîtier (8) et le côté de bride (21) de la bride (20) est placé un moyen d'étanchéité (22) et **en ce que** sur la seconde face frontale (12) du boîtier (8), autour du second orifice (14) de boîtier est placée une bague de support (23) avec une première face de bague (24) et une seconde face de bague (25), la première face de bague (24) de la bague de support (23) est adjacente à la seconde face frontale (12) du boîtier (8), la seconde face de bague (25) de la bague de support (23) est adjacente à la face supérieure (18) du premier porte-bobines (7), entre la première face de bague (24) de la bague de support (23) et la seconde face frontale (12) du boîtier (8) est placé un moyen d'étanchéité (22) et entre la seconde face de bague (25) de la bague de support (23) et la face supérieure (18) du premier porte-bobines (7) est placé un moyen d'étanchéité (22).

4. Débitmètre à résonance magnétique nucléaire selon la revendication 3, **caractérisé en ce que** dans les deux faces de bague (24, 25) de la bague de support (23) et dans le côté de bride (21) de la bride (20) sont prévus des évidements (26) destinés à recevoir les moyens d'étanchéité (22).

5. Débitmètre à résonance magnétique nucléaire selon la revendication 4, **caractérisé en ce qu'**entre le moyen d'étanchéité (22) inséré dans l'évidement (26) dans la seconde face de bague (25) de la bague de support (23) et la face supérieure (18) de la portion de forme tubulaire du premier porte-bobines (7), sur la face supérieure (18) de la portion de forme tubulaire du premier porte-bobines (7) est placé un adaptateur (27) et en commun avec le moyen d'étanchéité (22), l'adaptateur (27) permet un déplacement du premier porte-bobines (7) le long de l'axe longitudinal (9) du tube de mesurage (3) sans porter atteinte à l'étanchéité.

6. Débitmètre à résonance magnétique nucléaire selon l'une quelconque des revendications 3 à 5, **caractérisé en ce que** la bride (20) est dotée de perçages (28) destinés à faire passer des vis (29) et dans le boîtier (8), sur la première face frontale (11) sont conçus des taraudages (30) destinés à recevoir les vis (29).

7. Débitmètre à résonance magnétique nucléaire selon l'une quelconque des revendications 1 à 6, **caractérisé en ce que** le premier porte-bobines (7) est essentiellement constitué d'une matière composite fibreuse, notamment est essentiellement constitué d'une matière composite renforcée par fibres de verre.
